Europäisches Patentamt

(19) European Patent Office

Office européen des brevets

(11) Publication number: **0 100 529**
**B1**

# (12) EUROPEAN PATENT SPECIFICATION

(45) Date of publication of patent specification: **12.11.86**

(51) Int. Cl.⁴: **H 01 L 29/80**

(21) Application number: **83107446.3**

(22) Date of filing: **28.07.83**

(54) High speed field-effect transistor employing heterojunction.

(30) Priority: **29.07.82 JP 132609/82**

(43) Date of publication of application:
**15.02.84 Bulletin 84/07**

(45) Publication of the grant of the patent:
**12.11.86 Bulletin 86/46**

(84) Designated Contracting States:
**DE FR GB**

(56) References cited:
**EP-A-0 064 370**
**DE-A-2 913 068**
**FR-A-2 386 903**

**APPLIED PHYSICS LETTERS, vol. 40, no. 9, May 1982, New York. T. J. DRUMMOND et. al.: "A novel normally-off camel diode gate GaAs field-effect transistor", pages 834-836**
**Patent Abstracts of Japan, vol. 6, no. 151, 11 August 1982**

**IEEE ELECTRON DEVICE LETTERS, vol. EDL-1, no. 6, June 1980, New York. R. F. LEHENY et al.: "An In0.53Ga0.47As junction field-effect transistor", pages 110-111**

(73) Proprietor: **NEC CORPORATION**
**33-1, Shiba 5-chome, Minato-ku**
**Tokyo 108 (JP)**

(72) Inventor: **Ohata, Keiichi**
**c/o NEC Corporation 33-1, Shiba 5-chome**
**Minato-ku Tokyo (JP)**

(74) Representative: **Glawe, Delfs, Moll & Partner**
**Patentanwälte**
**Postfach 26 01 62 Liebherrstrasse 20**
**D-8000 München 26 (DE)**

(56) References cited:
**APPLIED PHYSICS LETTERS, vol. 40, no. 16, March 1982, New York. M. LAVIRON et al.: "Low noise normally on and normally off two-dimensional electron gas field-effect transistors", pages 530-532**

## Description

Background of the invention
Field of the invention
This invention relates to a high speed field-effect transistor ("FET") provided with a heterojunction using compound semiconductors.

Prior art
A heterojunction of n-GaAlAs and high purity GaAs layers formed by molecular beam epitaxy, a so-called modulation-doped structure, has an extremely high electron mobility at low temperatures such as that of liquid nitrogen. Therefore, the application of such a modulation-doped structure to FETs has been studied. For example, in Applied Physics Letter, Vol. 40, No. 6, Pages 530—532, an FET is proposed which comprises a layer of high-purity (p⁻-type) GaAs grown on a semi-insulating substrate, a thin n-type undoped GaAlAs layer grown thereon, an Si-doped GaAlAs layer grown on the undoped GaAlAs layer, a gate electrode forming a Schottky junction with the Si-doped GaAlAs layer and source and drain electrodes contacting ohmically with the Si-doped GaAlAs layer. The Si-doped and undoped GaAlAs layers under the gate electrode are completely depleted to form a normally-off type FET by a built-in potential of the Schottky barrier formed by the gate electrode. Electron density is increased to form N-type conductive layers at the interface of the GaAs layer and the undoped GaAlAs layer on portions where the gate electrode does not exist. An N-type conductive channel is formed at the interface of the GaAs layer and the undoped GaAlAs layer under the gate electrode by an electrical potential applied to the Schottky gate electrode by capacitive coupling with the depleted GaAlAs layers. Consequently, the transistor is actuated.

High speed operation can be obtained in such a transistor having a Hall mobility of 38,000 cm²V⁻¹sec⁻¹ at 77°K. However, this transistor exhibits drawbacks based on the Schottky junction type gate electrode. That is, to form a Schottky junction, the Si-doped GaAlAs layer must have low impurity density and reduced thickness. If not present, the depletion layer formed by the Schottky junction will be broken or it expands to an unfavorable extent. This results in a considerably high dynamic or internal resistance of the transistor. Further, because the breakdown voltage of the Schottky junction is essentially low, the voltage applicable to the gate is limited to a low voltage.

Furthermore, the n-type conductive channel at the interface of the GaAs and undoped GaAlAs layers is very sensitive to the surface state of the Si-doped GaAlAs layer. If the surface potential is high, the conductivity of the conductive channel becomes low or infinite. This adverse effect caused by the surface state can be removed by enlarging the thickness of the Si-doped GaAlAs layer except for the portion under the gate electrode or depositing an n⁺-type GaAs layer on the Si-doped GaAlAs layer except for the gate electrode portion. However, this additional structure adversely affects the planarity at the surface of the upper-most GaAlAs layer, resulting in an increased number of manufacturing steps, a difficulty in shaping the uppermost GaAlAs layer and a difficulty in obtaining a reliable surface passivation.

A FET as defined in the preamble part of claim 1 has been known from EP—A—0 055 968. In this prior art FET is an inversion region or accumulation region formed at the interface of first and second semiconductor layers of opposite conductivity types serves as the controllable channel between source and gate electrodes. The gate for controlling the channel is a metallic gate directly applied to the second semiconductor layer and forming a Schottky-contact therewith. As mentioned above this results in a high dynamic or internal resistance of the transistor, and the low breakdown voltage reduces the voltage applicable to the gate.

It is an object of the invention to obtain an FET operable at high speed with a small dynamic or internal resistance and a high voltage applicable to the gate electrode.

According to the invention there is provided a field effect transistor comprising: A first semiconductor layer which is intrinsic or of a first conductivity type having a density; a second semiconductor layer of a second conductivity type formed on said first semiconductor layer, said second semiconductor layer inducing a high mobility inversion layer at the interface with said first semiconductor layer as a result of the contact therebetween; a gate electrode formed on said second semiconductor layer, to control by capacitive coupling the conductivity of portion of said inversion layer under said electrode in response to the electrical potential applied to the gate electrode; a drain electrode and a source electrode formed on opposite sides of said gate electrode and connected electrically to said inversion layer, characterized in that said gate electrode includes a third semiconductor layer of the first conductivity type formed in contact with said second semiconductor layer and forming a p-n junction therewith whereby the impurity doping level of said third layer is made larger than the doping level of the second layer so that the depletion layer due to the junction extends into only the second layer, the thickness and/or the impurity doping level of the second layer being then made large enough so as to minimize the internal resistance.

For an n-channel FET the first conductivity type is p-type and the second conductivity type is n-type. The second semiconductor layer is a semiconductor which has a lower electron affinity than the first semiconductor layer. To the contrary, for the p-channel FET, the first conductivity type is n-type and the second conductivity type is p-type. The second semiconductor layer is a semiconductor which has a larger sum of electron affinity and energy band gap than the

first semiconductor layer. Further, in the case of a normally-off type FET, the impurity concentration of the third semiconductor layer should be selected to a value which extends the depletion layer over the total thickness of the second semiconductor layer when the third semiconductor is unbiased. For the normally-on type FET, the impurity concentration of the third semiconductor layer should be selected at a value which extends the depletion layer of the p-n junction over the total thickness of the second semiconductor layer when the third semiconductor layer is negatively biased.

According to this invention, a p-n junction gate is formed by the second semiconductor layer and the third semiconductor layer. The thickness of the depletion layer due to the p-n junction is generally larger than the depletion layer due to the Schottky junction and can be widely controlled by adjusting a difference in impurity density between the second semiconductor layer and the third semiconductor layer. That is, for obtaining the same depletion layer as the Schottky junction in the prior art, the impurity density of the second semiconductor layer may therefore be increased to correspondingly increase the carrier density of an inversion layer formed at the interface of the first and second semiconductor layers can be kept high accordingly. Thus an FET with a small dynamic or internal resistance can be obtained.

Furthermore, because the thickness of the depletion layer due to the p-n junction is essentially larger than the depletion layer due to the Schottky junction, the thickness of the second semiconductor layer may be increased. If the thickness of the second semiconductor layer is large, the inversion layer formed at the interface of the first and second semiconductor layer becomes free from the surface state of the second semiconductor layer. Thus a stable and highly conductive inversion layer is obtained at the interface of the first and second semiconductor layers. The thickness of the second semiconductor layer under the third semiconductor (gate) layer may be increased by controlling the impurity density of the second and/or third semiconductor layer. Therefore, the present invention enables the realization of an FET having stable electrical characteristics obtained without affecting the surface planarity, so that the achievement of an easy manufacturing process having a decreased number of manufacturing steps, the easy shaping of the second semiconductor layer, and the easy making of a surface passivation are made possible.

Another advantage of the invention is that a high voltage may be applied to the gate electrode. The barrier height and the reverse breakdown voltage of the p-n junction is exceptionally high compared to those of the Schottky junction. Therefore, the FET of this invention operates as a normal transistor even when an input signal with a large voltage is applied thereto.

Brief description of the drawings

The above and other features and objects of the invention will become more apparent from the following detailed description taken in conjunction with the accompanying drawings, wherein:

Fig. 1 is a cross sectional view of one example of a conventional FET;

Fig. 2 is an energy band diagram in a thermal equilibrium, taken along the line A—A' of Fig. 1;

Fig. 3 is an energy band diagram in a thermal equilibrium, taken along the line B—B' of Fig. 1;

Fig. 4 is a cross-sectional view of another example of a conventional FET;

Fig. 5 is a cross-sectional view of a still other example of a conventional FET;

Fig. 6 is a cross-sectional view of a first embodiment of the present invention;

Fig. 7(a) is an energy band diagram in a thermal equilibrium, taken along the line C—C' of Fig. 6;

Fig. 7(b) is an energy band diagram in a thermal equilibrium, taken along the line D—D' of Fig. 6;

Fig. 8 is an energy band diagram when a positive voltage is applied to the gate electrode of the first embodiment, taken along line C—C' of Fig. 6;

Fig. 9(a) to Fig. 9(e) are cross-sectional views of each stage of the process of manufacturing the first embodiment of the invention;

Fig. 10 is a cross-sectional view of a modification of the first embodiment of the invention;

Fig. 11 is an energy band diagram in a thermal equilibrium, taken along the line E—E' of Fig. 10;

Fig. 12 is a cross-sectional view of a second embodiment of the invention;

Fig. 13 is a cross-sectional view of a third embodiment of the invention; and

Fig. 14 is an energy band diagram in a thermal equilibrium at the section of the gate region of a fifth embodiment of the invention.

Detailed description of the invention

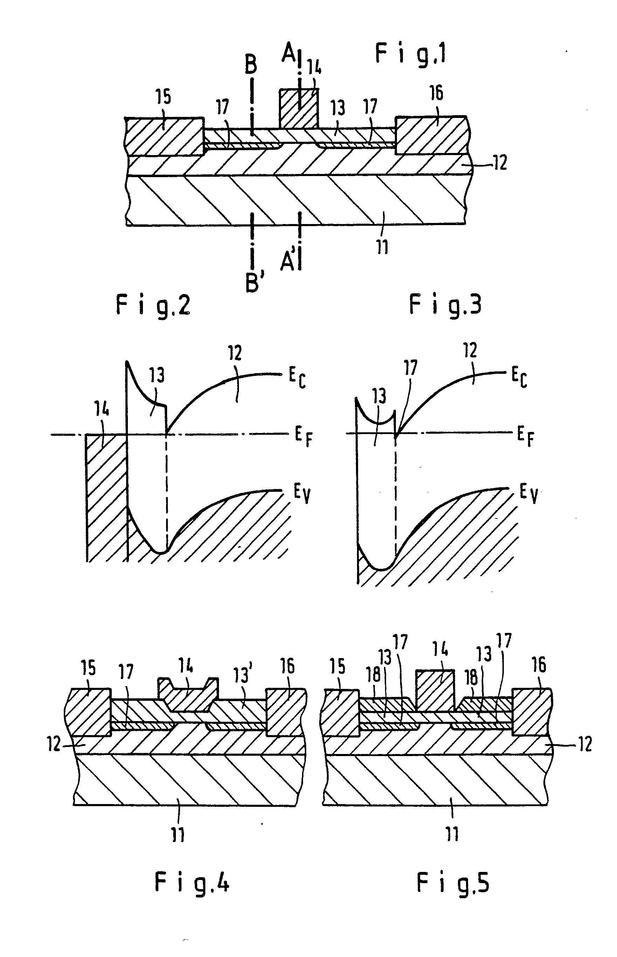

Referring to Fig. 1, an FET with a conventional modulation-doped structure includes a high-purity GaAs layer 12 free from impurities and formed on a GaAs substrate 11 semi-insulated by Cr doped therein. An n-type GaAlAs layer 13 in which an impurity of Si or the like is doped is provided on the layer 12. Source and drain electrodes 15 and 16 are formed by depositing a metal on the layer 13 and diffusing the metal into the GaAlAs layer 13 to reach the layer 12. A gate electrode 14 isolated from but located between the source and drain electrodes 15 and 16 is formed to make a Schottky junction with the layer 13.

In a state of thermal equilibrium, the energy band diagram at a portion between the gate electrode 14 and the source or drain electrode 15 or 16 (B—B' in Fig. 1) is shown in Fig. 3. In Figs. 2 and 3, $E_F$ denotes the Fermi level, $E_C$ the level of the lower edge of the conduction band, and $E_V$ the level of the upper edge of the valence band. The surface potential of the n-type GaAlAs layer 13 is so small that the surface depletion layer due to the surface potential is thinner than the total thickness of the layer 13, and consequently, the surface depletion layer never reaches the high-purity GaAs layer 12. A quantity of electrons corresponding to the charge due to an ionized donor impurities in the layer 13 form electron layers 17 at the interface of the GaAlAs layer 13 and the GaAs layer 12. The electron layers 17 are connected in ohmic contact to the source and drain regions.

On the other hand, the energy band diagram at a portion under the gate electrode (A—A' in Fig. 1) is shown in Fig. 2 as a case of a normally-off type FET. The thickness and impurity density of the n-type GaAlAs layer 13 are established so that layer 13 is depleted over the total thickness thereof by the built-in potential of the Schottky barrier due to the contact with the gate electrode 14. Therefore, no electron layer is formed at the interface of the layers 12 and 13 under the electrode 14. Consequently, in the absence of any potential applied to the gate electrode 14, no conductive channel is formed between the source and drain electrodes 15 and 16, with the result that no current flows. By the application of a positive voltage to the electrode 14, electrons are generated at the interface of the GaAs layer 12 and the GaAlAs layer 13 by capacitive coupling with the layer 13 to form an n-type conductive channel between the electron layers 17. Thus, current flows between the source and drain electrodes 15 and 16. As described herein, the semiconductor device shown in Fig. 1 operates as an FET which amplifies an input signal applied to the gate electrode 14.

For the semiconductor device of Fig. 1, to operate as an FET with a small internal resistance, the layers 17 must be kept at a sufficiently low specific resistance. This may be achieved by sufficiently increasing the impurity density of the n-type GaAlAs layer 13 to cause the gate electrode to be brought into ohmic contact with the layer 13. Another method for keeping the layers 17 at a sufficiently low specific resistance without adjusting the impurity density of the layer 13, is to keep the surface potential of the layer 13 sufficiently small. However, the surface control of Group III—V compound semiconductors is not an easy task. If the surface potential of the GaAlAs layer 13 is high, the surface depletion layer extends to decrease the number of carrier in the electron layers 17, resulting in an increase in a specific resistance of the layers 17. In particular, when the surface potential increases to a value the same as the surface potential under the gate elect ode 14, the electron layers 17 disappear.

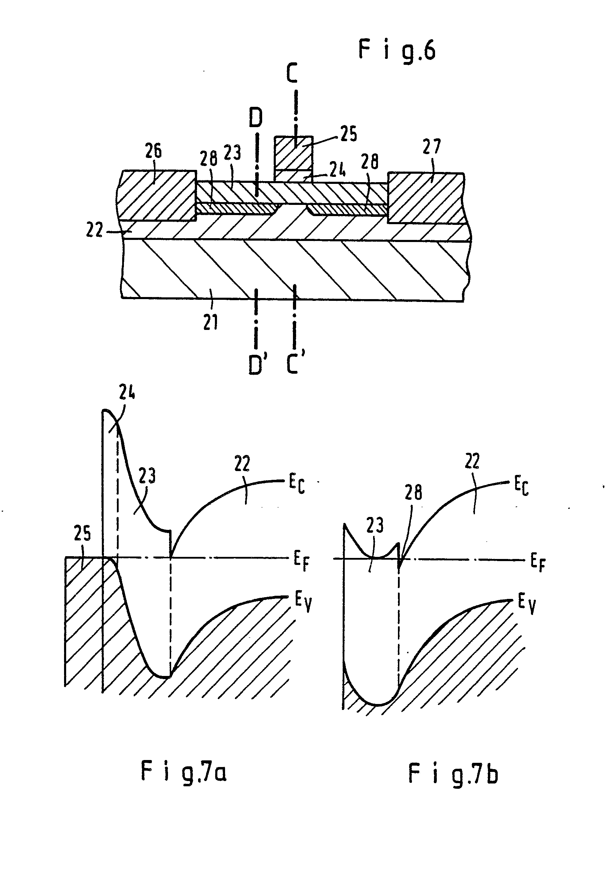

Conceivable structures for eliminating these influences exerted by the surface potential have been proposed. Fig. 4 shows one of these proposals wherein an n-type GaAlAs layer 13' is formed thick except at the portion under the gate electrode 14. The depletion layer extended by the surface potential stays removed from the GaAs layer 12 in the thick GaAlAs layer 13'. Accordingly, the influence of the surface potential to the electron layers 17 is minimized. Fig. 5 shows another proposal wherein an n$^+$-type GaAs layer 18 having a high impurity density is provided over the n-type GaAlAs layer 13 except where the gate electrode 14 exists. Similar to the thick GaAlAs layer 13', the depletion layer due to the surface potential of the GaAs layer 18 is maintained away from the GaAs layer 12 to minimize the influence of the surface potential to the electron layers 17. However, the structures of Figs. 4 and 5 adversely affect the flatness of the GaAlAs layer 13, which makes it difficult to manufacture the FET. This is attributed to an increased number of manufacturing steps, difficult formation of the GaAlAs layer 13' and the GaAs layer 18, and unreliable passivation of the device surface due to fine unevenness. It is also difficult to form the FET in a monolithic integrated circuit.

Another disadvantage of the conventional FET is that, as will be apparent from Fig. 2, the height of the barrier between the gate electrode 14 and the electrons to be produced at the interface of the GaAs layer 12 and the GaAlAs layer 13 under the gate electrode 14 is nearly the same as the usual metal-semiconductor junction and is only 0.8 eV. Accordingly, a large positive voltage cannot be applied to the gate electrode 14. In other words, the possible input signals are limited to small voltages.

Referring now to Fig. 6, a first embodiment of the invention comprises a p$^-$-type GaAs layer 22 with an effective acceptor density of approximately $1 \times 10^{14}$ cm$^{-3}$, which is formed to have a thickness of several microns over a semi-insulating GaAs substrate 21 with Cr doped therein. A lower acceptor density would be preferable for making the p$^-$-type GaAs layer 22. An acceptor density of about $1 \times 10^{14}$ cm$^{-3}$ does not affect the device operation, but it should be less than $1 \times 10^{16}$ cm$^{-3}$, to maintain high mobility. An n-type Ga$_{0.7}$Al$_{0.3}$As layer 23 with an effective density of $5 \times 10^{17}$ cm$^{-3}$ and a thickness of about 600 Å is provided on the GaAs layer 22. The donor density of the GaAlAs layer 23 is preferably selected in a range of $1 \times 10^{17}$ cm$^{-3}$ and $1 \times 10^{19}$ cm$^{-3}$. A p-type Ga$_{0.7}$Al$_{0.3}$As for layer 24 to have an effective acceptor density of $1 \times 10^{19}$ cm$^{-3}$, a thickness of about 100 Å and a width of about 0.5 μm is provided on the GaAlAs layer 23 at its center to form a p-n junction therewith. A metallic gate electrode 25 of Al, for example, is formed in ohmic contact with the p$^+$-type GaAlAs layer 24. The impurity density of the layer 24 should be higher than that of the GaAlAs layer 23 and selected to be a value high enough to allow the depletion layer to extend in the n-type GaAlAs layer 23 to reach the p$^-$-type GaAs layer 22 when unbiased. Source and drain electrodes 26 and 27 are formed in the following steps.

An alloy of Au and Ge is evaporated on the GaAlAs layer 23 at the portion where the electrodes 26 and 27 are formed, followed by the evaporation of Ni onto the alloy of Au and Ge. Thereafter, by alloying the Ni and the alloy of Au and Ge with the GaAlAs layer 23 and the GaAs layer 22 in an annealing procedure, the metallic alloy thereof is grown downwardly to reach the interface of the layers 22 and 23. The formed metallic alloy is used as the source electrode 26 and the drain electrode 27. Therefore, the metallic alloy must have a property to ohmic contact with carrier (electron in this case) layers 28 at the interface of the layers 22 and 23.

As alternative materials, a semi-insulative InP may be used for the semi-insulative GaAs 21. Similarly, a high-purity InGaAs may be substituted for the high-purity GaAs layer 22, n-type InP or n-type AlInAs for the n-type GaAlAs 23 and $p^+$-type InP or $P^+$-type AlInAs for the $P^+$-type GaAlAs 24. It will be appreciated that the conductivity type of all the semiconductor layers 22, 23, and 24 may be reversed to obtain a p-channel type FET. For such p-channel transistor, the upper limit of the donor density should be $1 \times 10^{16}$ cm$^{-3}$ to maintain a high mobility.

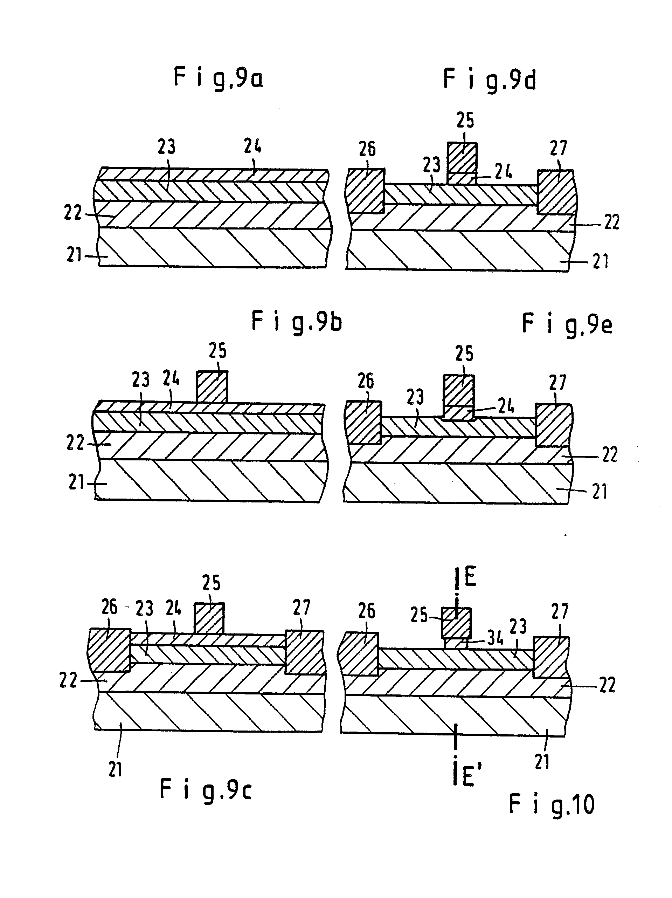

Next is shown a mode wherein the FET constituted as above operates as a normally-off transistor. Figs. 7(a) and 7(b) are energy band diagrams in thermal-equilibrium, wherein Fig. 7(a) is a section view taken along the line C—C' (gate region) of Fig. 6 and Fig. 7(b) is taken along the line D—D' (between gate and source regions) of Fig. 6. Fig. 8 is an energy band diagram taken along the line C—C' of Fig. 6 when an n-channel 29 is formed at the interface of the GaAs layer 22 and the GaAlAs layer 23 under the GaAlAs layer 24 by applying a positive voltage to the gate electrode 25. In the drawing, $E_F'$ denotes the quasi-Fermi level. Namely, in the thermal equilibrium, the layer 23 under the layer 24 is completely depleted only by the diffusion potential difference of the p-n junction with the layer 24. Accordingly, electrons are not stored at the interface of the n-type GaAlAs layer 23 and the $p^-$-type GaAs layer 22, with the result that no electron layer is formed. This mode is illustrated in Fig. 7(a). On the other hand, electron layers 28 are formed at the interface of the layers 23 and 22 except for the portion under the p-type GaAlAs layer 24, as shown in Fig. 7(b). The electron layers 28 are in ohmic contact with the source and drain electrodes 26 and 27 and operate essentially as a source region and a drain region. By applying a positive voltage to the gate electrode 25, electrons are produced at the hetero interface of the n-type GaAlAs layer 23 and the $p^-$-type GaAs layer 22 in the gate region by capacitive coupling with the depleted layer 23 so as to form an electron layer 29 shown in Fig. 8. A current flows between the source and drain electrodes 26 and 27 through the layer 29 and the electron layers 28, thus producing the transistor operation.

With the embodiment of Fig. 6, since the diffusion potential of the p-n junction is larger than the built-in potential of the Schottky barrier, the FET of Fig. 6 may have a thick n-type GaAlAs layer 23 and/or a high donor density of the layer 23. In order to extend the depletion layer due to the junction of the GaAlAs layers 23 and 24 into only the n-type GaAlAs layer 23, the impurity doping level of the $p^+$-type GaAlAs layer 24 should be made larger than the impurity doping level of the layer 23. Thus, the electron storage in the electron layers 28 at the interface of the $p^-$-type GaAs layer 22 and the n-type GaAlAs layer 23 can be made larger by increasing the thickness and/or the impurity doping level of the layer 23 to minimize the internal resistance of the FET. It is preferable that the $p^+$-type GaAlAs layer 24 is somewhat thicker than the depletion layer due to junction between the layers 23 and 24 extending to the layer 24. However, when the impurity is doped at a high density as in this embodiment above, any extension of the depletion layer is limited. As a result, the $p^+$-type GaAlAs layer 24 can be made thin, so that the unevenness of the surface can be suppressed to a degree almost similar to that of a planer FET.

The first embodiment of Fig. 6 will now be compared with conventional examples. A $p^-$-type GaAs layer which is $1 \times 10^{14}$ cm$^{-3}$ in effective acceptor density is used for the GaAs layer 12, and an n-type $Ga_{0.7}Al_{0.3}As$ layer with an effective donor density of $5 \times 10^{17}$ cm$^{-3}$ is used for the n-type GaAlAs layer 13. The barrier height of the Schottky gate is given at 0.8 eV, and the surface potential of the layer 13 other than the portion under the gate electrode is given at 0.4V, the same as the surface potential of the n-type GaAlAs layer 23 of this invention. Further, it is assumed that the interfaces between each of the semiconductor layers 11, 12 and 13 are formed abruptly to perfection. In the conventional examples, the thickness of the n-type GaAlAs layer 13 in the normally-off FET is about 350 Å, the surface potential of the GaAlAs layer 13 is 0.4V, and the sheet density of electrons in the electron layers 17 at the interface of the layers 12 and 13 is about $7 \times 10^{11}$ cm$^{-2}$. On the other hand, in this invention, the normally-off FET having the same threshold voltage as the conventional examples can have the thickness of the n-type GaAlAs layer 23 increased to about 600 Å, and hence the surface density of electrons in the electron layers 28 at the interface of the GaAs layer 22 and the GaAlAs layer 23 may grow very high to about $1.4 \times 10^{12}$ cm$^{-2}$ when compared with the conventional examples.

In the first embodiment of Fig. 6, the thickness of the n-type GaAlAs layer 23 can be maintained at about 400 Å even after increasing the effective donor density of the n-type GaAlAs layer 23 to $1 \times 10^{18}$ cm$^{-3}$. In this case, the surface density of electrons in the electron layers 28 at the interface of the GaAs layer 22 and the GaAlAs layer 23 becomes about $2 \times 10^{12}$ cm$^{-2}$, and the internal resistance of the transistor can be further decreased. Furthermore, in the conventional examples, if the surface potential of the n-type GaAlAs layer 13 increases and thus becomes the same as that of the part under the gate electrode 14, the electron layers 17 will not be formed, therefore source and drain resistances become infinite. In this invention, however, if the surface potential of the n-type GaAlAs layer 23 is the same as the surface potential under the gate electrode of the conventional examples, there is still a density of about $1 \times 10^{12}$ cm$^{-3}$ electrons in the electron layers 28. As described, in this invention, the internal resistance of the transistor is not influenced much by the surface potential of the n-type GaAlAs layer 23.

Further, in this invention, the height of the barrier of the gate electrode against electrons in the channel to be formed between the electron layers 28 is about 1.8 eV, which is so very high it is at least twice that of a conventional Schottky gate. Therefore, the range of input signal voltage to be applied is much higher than that for the conventional examples.

Next, the fundamental manufacturing process of an FET according to the above first embodiment will be described with reference to Figs. 9(a) to 9(d). The high-purity GaAs layer 22, n-type GaAlAs layer 23 and p$^+$-type GaAlAs layer 24 are grown consecutively onto the semi-insulating GaAs substrate 21 by, for example, molecular beam epitaxy (Fig. 9(a)). An Al film, for example, is disposed over the whole surface of the p$^+$-type GaAlAs layer 24, and then etched selectively to form the gate electrode 25 (Fig. 9(b)). Alternatively, the gate electrode 25 is formed by covering the unwanted parts of the p$^+$-type GaAlAs layer 24 with a film of photoresist, depositing Al film over the entire surface, and then removing the Al film on the photoresist together with the photoresist. The source electrode 26 and the drain electrode 27 are formed by, for example, plating an alloy of Au and Ge and a film of Ni consecutively on the GaAlAs layer 24 and alloying the metals with the semiconductors of the layers 24, 23 and 22 (Fig. 9(c)). Next, the p$^+$-type GaAlAs layer 24 between the gate electrode 25 and the source electrode 26, and between the gate electrode 25 and the drain electrode 27 is removed by etching (Fig. 9(d)). The process shown in Fig. 9(c) of forming the source and drain electrodes 26 and 27 is not necessarily limited to where they are formed after the gate electrode 25 is formed; they can be formed at any time after all the semiconductor layers 22, 23 and 24 have been grown. For etching the p$^+$-type GaAlAs layer 24 in the process of Fig. 9(d), the gate electrode 25 can be used as a mask for etching. The etching of the GaAlAs layer 24 can also be done while measuring the current/voltage characteristics of two or three of the gate, source and drain electrodes 25, 26 and 27. The timing for stopping etching for minimizing the source resistance can easily be determined by measuring the current/voltage characteristics at the same time of etching.

Furthermore, the semiconductor device of the invention is capable of controlling its threshold voltages by the diffusion of an acceptor impurity from the p$^+$-type GaAlAs layer 24 by heat treatment into the n-type GaAlAs layer 23. Specifically, when Be, Zn, etc., are used as acceptor impurities in the p$^+$-type GaAlAs layer 24, these acceptor impurities can be diffused at temperature 600°C, for example, much lower than that at which the donor impurities (Si, for example) of the n-type GaAlAs layer 23 diffuse, therefore the position of the p-n junction between the p$^+$-type GaAlAs layer 24 and the n-type GaAlAs layer 23 can be shifted to the layer 23 side without affecting the heterojunction of the layer 23 and the high-purity GaAs layer 22. The threshold voltage can accordingly be shifted to the positive side. The above heat treatment can be done at any time during the process shown in Fig. 9(a) to Fig. 9(d). When it is carried out after the processing level shown in Fig. 9(d), the sectional structure of the transistor is shown in Fig. 9(e). The heat treatment carried out after the process of Fig. 9(d) allows the diffusion to be caused while measuring the characteristics, which is convenient for controlling the threshold voltage.

Other semiconductors can be used in the first embodiment of this invention. For example, a p$^+$-type GaAs layer 34 can be employed, as shown in Fig. 10, instead of the p$^+$-type GaAlAs layer 24. When a p$^+$-type GaAs layer 34 is employed, an etchant which does not etch the n-type GaAlAs layer 23 or which has an extremely small etching rate for n-type GaAlAs can be selected as the etchant for selectively etching the p$^+$-type GaAs layer (34). By using such an etchant, not only can be etching accuracy be improved but also an FET with a short effective gate length can be obtained by etching the p$^+$-type GaAs layer 34 to a given shape with the gate electrode 25 acting as an etching mask, and then further side-etching the layer 34. Alkaline KI$_3$, KI and KOH aqueous solutions can be used as the etchant in this case.

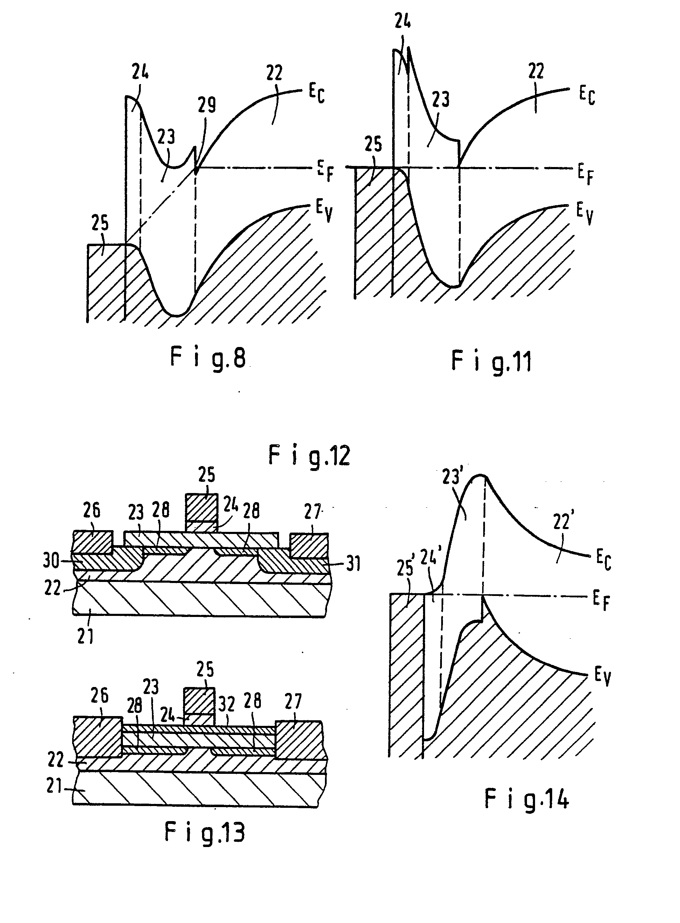

According to this modification, the thermal equilibrium energy band diagram of the gate electrode portion at the section E—E' of Fig. 10 is shown in Fig. 11. The height of the gate barrier is somewhat decreased as compared with the case wherein the p$^+$-type Ga$_{0.7}$Al$_{0.3}$As layer 24 is used. However, the surface density of electrons in the electron layers at the interface of the p$^-$-type GaAs layer 22 and the n-type GaAlAs layer 23 remains almost unchanged.

Other embodiments of the present invention will be described with reference to Figs. 12 and 13. In Figs. 12 and 13, like reference numerals refer to parts similar to those in the first embodiment of Fig. 6, accordingly no further description will be given therefor.

According to a second embodiment shown in Fig. 12, N$^+$ regions 30 and 31 are formed near the source and drain electrodes 26 and 27 so that electrons are smoothly supplied and efficiently collected to and from the electron layers 28 at the interface of p$^-$-type GaAs layer 22 and the n-type GaAlAs layer 23. According to this embodiment, since the electrons are supplied from the N$^+$ regions 30 and 31, not only can the internal resistance of the field-effect transistor be decreased, but also the ohmic contacts of the source and drain electrodes 26 and 27 can be improved.

Referring to Fig. 13, a third embodiment of the invention has an $n^+$-type GaAs layer 32 provided over the n-type GaAlAs layer 23 and the $p^+$-type GaAs layer 24 provided over the layer 32. Oxidation and deterioration with time of the n-type GaAlAs layer 23 can be prevented by the $n^+$-type GaAs layer 32. Further, the surface potential of the n-type GaAlAs layer 23 can be maintained low by the $n^+$-type GaAs layer 32, thus increasing the sheet density of electrons in the electron layers 28. It is not necessary for the layer 32 to form a definite layer. The layer 32 may be in any state that will allow the n-type GaAlAs layer 23 to change from GaAlAs to GaAs gradually toward the surface.

Modifications of this invention may also be practised. For example, in one modification the device is fundamentally the same in structure as that of Fig. 6 except that high-purity GaAlAs in which no impurity is doped is applied over the portion wherein the n-type GaAlAs layer 23 abuts the $p^-$-type GaAs layer 22. The electron mobility at the interface between the $p^-$-type GaAs layer 22 and the GaAlAs layer 23 can be further increased.

According to another modification of this invention, a p-channel FET can be obtained. The fundamental structure is the same as that of Fig. 6. The energy band structure will be described with reference to Fig. 14 showing the energy band diagram in the region of the gate electrode. A first semiconductor layer 22' of high-purity or n-type low-impurity density is provided on a high-resistance substrate. A second semiconductor layer 23' which is p-type with a larger sum of electron affinity and band gap than that of the first semiconductor layer 22' is provided over the first layer 22'. A gate electrode 25' is provided on the p-type layer 23' over an n-type layer 24'. The source and drain electrodes are disposed on either side of the gate electrode 25'. The thermal equilibrium energy band diagram of the gate region is shown in Fig. 14. As is apparent from Fig. 14, the p-type layer 23' is completely depleted in the gate region, and the transistor action is effected by capacitive coupling with the depleted semiconductor layer. Ge can be used for the first semiconductor layer 22' and GaAs can be used for the layer 23' and the layer 24'.

## Claims

1. A field effect transistor comprising:

A first semiconductor layer (22) which is intrinsic or of a first conductivity type having a low impurity density;

a second semiconductor layer (23) of a second conductivity type formed on said first semiconductor layer (22), said second semiconductor layer inducing a high mobility inversion layer (28) at the interface with said first semiconductor layer (22) as a result of the contact therebetween;

a gate electrode (24, 25) formed on said second semiconductor layer (23) to control by capacitive coupling the conductivity of portion of said inversion layer (28) under said electrode in response to the electrical potential applied to the gate electrode;

a drain electrode (27) and a source electrode (26) formed on opposite sides of said gate electrode (24, 25) and connected electrically to said inversion layer (28), characterized in that said gate electrode (24, 25) includes a third semiconductor layer (24) of the first conductivity type formed in contact with said second semiconductor layer (23) and forming a p-n junction therewith whereby the impurity doping level of said first layer (24) is made larger than the doping level of the second layer (23) so that the depletion layer due to the junction extends into only the second layer (23), the thickness and/or the impurity doping level of the second layer (23) being then made large enough so as to minimize the internal resistance.

2. A field effect transistor as claimed in claim 1, wherein said second and third semiconductor layers (23, 24) are made of the same semiconductor material.

3. A field effect transistor as claimed in claim 1, wherein a lower part of said third semiconductor layer (24) is embedded into said second semiconductor layer (23) by diffusing an impurity contained in said third semiconductor layer into said second semiconductor layer from said third semiconductor layer.

## Patentansprüche

1. Feldeffekttransistor mit:

einer ersten Halbleiterschicht (22), die intrinsisch oder von einem ersten Leitfähigkeitstyp mit geringer Verunreinigungsdichte ist;

einer auf der ersten Halbleiterschicht (22) ausgebildeten zweiten Halbleiterschicht (23) eines zweiten Leitfähigkeitstyps, wobei die zweite Halbleiterschicht an der Grenzfläche zu der ersten Halbleiterschicht (22) aufgrund des gegenseitigen Kontaktes eine Inversionsschicht (28) mit hoher Beweglichkeit hervorruft;

einer auf der zweiten Halbleiterschicht (23) ausgebildeten Gate-Elektrode (24, 25), um durch kapazitive Kupplung die Leitfähigkeit des unter der Elektrode liegenden Teils der Inversionsschicht (28) in Abhängigkeit von dem der Gate-Elektrode zugeführten elektrischen Potential zu steuern;

einer Drain-Electrode (27) und einer Source-Elektrode (26), die auf gegenüberliegenden Seiten der Gate-Elektrode (24, 25) ausgebildet sind und elektrisch mit der Inversionsschicht (28) verbunden sind, dadurch gekennzeichnet, daß die Gate-Elektrode (24, 25) eine dritte Halbleiterschicht (24) des ersten Leitfähigkeitstyps aufweist, die in Kontakt mit der zweiten Halbleiterschicht (23) ausgebildet ist und mit ihr einen p-n-Übergang bildet, wodurch der Verunreinigungsdotierungsgrad der ersten Schicht (24) größer gemach wird als der Dotierungsgrad der zweiten Schicht (23), so daß die aufgrund des Übergangs auftretende Verarmungsschicht sich nur in die zweite Schicht (23) erstreckt, wobei die Dicke und/oder der Verunreinigungsdotierungsgrad der zweiten Schicht (23) genug erhöht wird, um den inneren Widerstand zu minimieren.

2. Feldeffekttransistor nach Anspruch 1, dadurch gekennzeichnet, daß die zweite und die dritte Halbleiterschicht (23, 24) aus dem gleichen Halbleitermaterial gefertigt sind.

3. Feldeffekttransistor nach Anspruch 1, dadurch gekennzeichnet, daß der untere Teil der dritten Halbleiterschicht (24) in die zweite Halbleiterschicht (23) durch Diffusion einer in der dritten Halbleiterschicht enthaltenen Verunreinigung aus der dritten Halbleiterschicht in die zweite Halbleiterschicht eingefügt wird.

**Revendications**

1. Transistor à effet de champ comprenant:

— une première couche de semi-conducteur (22) qui est intrinsèque ou d'un premier type de conductivité ayant une faible densité en impureté;

— une seconde couche de semi-conducteur (23) d'un second type de conductivité formée sur ladite première couche de semi-conducteur (22), ladite seconde couche de semi-conducteur induisant une couche d'inversion de haute mobilité (28) à l'interface avec ladite première couche de semi-conducteur (22) du fait du contact entre celles-ci;

— une électrode de grille (24, 25) formée sur ladite seconde couche de semi-conducteur (23) pour commander par couplage capacitif la conductivité d'une partie de ladite couche d'inversion (28) sous ladite électrode en réponse au potentiel électrique appliqué à l'électrode de grille;

— une électrode de drain (27) et une électrode de source (26) formées sur les côtés opposés de ladite électrode de grille (24, 25) et connectées électriquement à ladite couche d'inversion (28),

caractérisé en ce que ladite électrode de grille (24, 25) comporte une troisième couche de semi-conducteur (24) du premier type de conductivité formée au contact de ladite seconde couche de semi-conducteur (23) et formant une jonction p-n avec celle-ci, le taux de dopage par des impurétes de ladite première couche (24) étant rendu plus important que le taux de dopage de la seconde couche (23) de façon à ce que la couche d'appauvrissement résultant de la jonction ne se prolonge que dans la seconde couche (23), l'épaisseur et/ou le taux de dopage par des impuretés de la seconde couche (23) étant ensuite choisi de façon à être suffisamment important pour rendre minimale la résistance interne.

2. Transistor à effet de champ selon la revendication 1, caractérisé en ce que lesdites seconde et troisième couches de semi-conducteur (23, 24) sont constituées du même matériau semi-conducteur.

3. Transistor à effet de champ selon la revendication 1, caractérisé en ce qu'une partie inférieure de ladite troisième couche de semi-conducteur (24) est noyée dans ladite seconde couche de semi-conducteur (23) par diffusion d'une impureté contenue dans ladite troisième couche de semi-conducteur, au sein de la seconde couche de semi-conducteur à partir de ladite troisième couche de semi-conducteur.

F i g.1

F i g.2

F i g.3

F i g.4

F i g.5

1

F i g.6

F i g.7a    F i g.7b

# Fig.9a

# Fig.9d

# Fig.9b

# Fig.9e

# Fig.9c

# Fig.10

F i g.8

F i g.11

F i g.12

F i g.13

F i g.14